# EUROPÄISCHE PATENTSCHRIFT

(11) **EP 0 897 219 B1**
(45) Veröffentlichungstag und Bekanntmachung des Hinweises auf die Patenterteilung: **10.09.2003**
(21) Anmeldenummer: 98250202.3
(22) Anmeldetag: 10.06.1998
(51) Int. Cl.: H03K 17/0814

(54) **Schaltungsanordnung zur Verlustleistungsentlastung von Leistungshalbleiterschaltern in Gleichstromstellern**
Snubber circuit arrangement against power dissipation of power semiconductor switches in DC-choppers
Montage d'aide à la commutation agissant contre la dissipation de puissance des commutateurs de puissance à semi-conducteurs dans les hacheurs à courant continu

(30) Priorität: 09.08.1997 DE 19735576
(43) Veröffentlichungstag der Anmeldung: 17.02.1999
(73) Patentinhaber: DaimlerChrysler Rail Systems GmbH, 13627 Berlin (DE)
(72) Erfinder: Salama, Samir, Dr., 13591 Berlin (DE)
(74) Vertreter: Thielmann, Andreas

(56) Entgegenhaltungen:
- DE-A- 4 210 092

## Beschreibung

Die Erfindung betrifft eine Schaltungsanordnung zur Veriustleistungsentlastung eines Leistungshalbleiterschalters, der in Reihe mit einer Last im Zweig einer Gleichspannungsquelle liegt, wobei antiparallel zur Last eine Freilaufdiode angeordnet ist, insbesondere für Gleichstromsteller.

Beim Betrieb von Leistungshalbleitern als elektronische Schalter in Stromrichterschaltungen müssen bekanntlich außer den Größen Durchlaßstrom und Sperrspannung auch deren Änderungsgeschwindigkeiten beim Einschalt- bzw. Abschaltvorgang unterhalb gewisser Grenzwerte gehalten werden, um Fehlfunktionen oder Zerstörung zu vermeiden.

Die für diese Aufgabe benötigten Beschaltungen aus Blindelementen, Dioden und Widerständen haben bei zweckmäßiger Ausgestaltung die günstige Wirkung, auch die Spitzenverlustleistung, die während der Schaltvorgänge in den steuerbaren Halbleiterschaltern auftritt, zu reduzieren. Dieser Entlastungseffekt ist insbesondere wegen der hieraus resultierenden Verminderung der mittleren Verlustleistung, die bei periodischem Schaltbetrieb zur Erwärmung des Halbleitersystems führt, sehr erwünscht.

Bei konventionellen Beschaltungsnetzwerken müssen jedoch die in den Blindelementen gespeicherten Energien in linearen oder nichtlinearen Widerständen in Wärme umgesetzt werden, so daß die Verluste letztlich nur verlagert werden (DE 21 28 454 A1).

Aus der DE 26 44 715 C2 sind Abschaltentlastungsnetzwerke bekannt, die ohne prinzipbedingte Verluste arbeiten. Außerdem sind ebenda Netzwerke zur Einschaltentlastung und Kombination dieser mit Abschaltentlastungsnetzwerken angegeben. Die dargestellten Einschaltentlastungen arbeiten jedoch mit Umsetzung der gespeicherten Energie in thermische Verluste. Ebenso gelingt es mit den kombinierten Ein- und Abschaltentlastungsnetzwerken nicht, prinzipbedingte Verluste zu vermeiden. Auch ist der Schaltungsaufwand verhältnismäßig hoch.

Weitere elektronische Schaltungen zur Rückspeisung der gespeicherten Energie, z.B. in Form von Gleichstromstellern, wie beispielsweise in der schon zitierten DE 26 44 717 C2, Anspruch 9 beschrieben, erfordern einen erheblichen zusätzlichen Aufwand und stellen zudem nur eine Verschiebung der Probleme dar.

In der DE 31 20 469 C2 sind Beschaltungen für Gleichstromsteller angegeben, die eine Kombination eines Ein- und Abschaltentlastungsnetzwerkes aufweist, die ohne prinzipbedingte Verluste arbeiten. Für eine ordnungsgemäße Funktion dieser Beschaltungen muß allerdings die Energie des Beschaltungskondensators um 1/2CU² größer als die Energie der Beschaltungsinduktivität 1/2LI² sein. Es existiert deshalb eine Stromgrenze Imax <= U √ L/C, die durch Kompromisse bei der Dimensionierung der Beschaltungsbauelemente L und C festgelegt werden muß. Beim Abschalten von Lastströmen größer der Stromgrenze Imax wird der Drosselstrom nicht mehr vollständig abgebaut.

Der vorliegenden Erfindung liegt die Aufgabe zugrunde, die eingangs angegebene Schaltungsanordnung derart zu gestalten, daß
- sie ein Einschaltentlastungsnetzwerk ohne prinzipbedingte Verluste aufweist,
- sie eine Kombination eines Ein- und Abschaltentlastungsnetzwerks ohne prinzipbedingte Verluste aufweist,
- ein möglichst geringer Aufwand an Bauelementen, insbesondere auch eine Rückspeisung der gespeicherten Energie ohne Verwendung zusätzlicher steuerbarer elektronischer Schalter erreicht wird und daß
- keine Einschränkung bezüglich der Höhe des abzuschaltenden Stromes besteht.

Die Aufgabe wird erfindungsgemäß durch die im kennzeichnenden Teil der Ansprüche 1 und 2 angegebenen Merkmale gelöst. Vorteilhafte Weiterbildungen geben die Unteransprüche 3 bis 10 an.

Beim Einschalten wird durch die beiden Beschaltungsdrosseln die Anstiegsgeschwindigkeit des Stromes im Leistungshalbleiterschalter soweit begrenzt, daß sich die Einschaltverluste des Leistungshalbleiterschalters erheblich reduzieren. Beim Abschalten wird die Energie beider Beschaltungsdrosseln zunächst in einem Speicherkondensator zwischengespeichert und dann in die Last zurückgespeist.
Nach einer zum Zwecke der Abschaltentlastung erweiterten Ausführung wird beim Abschalten der Laststrom zunächst in einen zusätzlichen Beschaltungskondensator kommutiert, der beim Einschalten auf Null umgeladen wird, indem seine Energie ebenfalls im vorerwähnten Speicherkondensator zwischengespeichert wird, bis letztlich die Rückspeisung in die Last erfolgt.

Wegen der nahezu verlustlosen Arbeitsweise der erfindungsgemäßen Beschaltung kann das Maß der Schaltentlastung großzügig gewählt werden. Dies ermöglicht es, den Leistungshalbleiterschalter hoch auszunutzen.

Die Erfindung soll anhand eines Ausführungsbeispiels und der zugehörigen Zeichnung näher erläutert werden. Hierzu zeigten:
- Fig. 1: eine Schaltungsanordnung zur Einschaltentlastung ohne prinzipbedingte Verluste am Beispiel eines Tiefsetzstellers,
- Fig. 2a: eine unbeschaltete Freilaufdiode eines Gleichstomstellers nach dem Stande der Technik,
- Fig. 2b: die Freilaufdiode nach Fig. 2a mit einem Einschaltentlastungsnetzwerk beschaltet,
- Fig. 3: eine zwecks Abschaltentlastung erweiterte Schaltungsanordnung nach Fig. 1 ohne prinzipbedingte Schaltverluste,
- Fig. 4: eine Variante zur Abschaltentlastung nach Fig. 3,
- Fig. 5: die Strom- und Spannungsverläufe beim Ein- und Abschalten des elektronischen Schalters nach Fig. 1,
- Fig. 6: die Strom- und Spannungsverläufe beim Ein- und Abschalten des elektronischen Schalters nach Fig. 4.

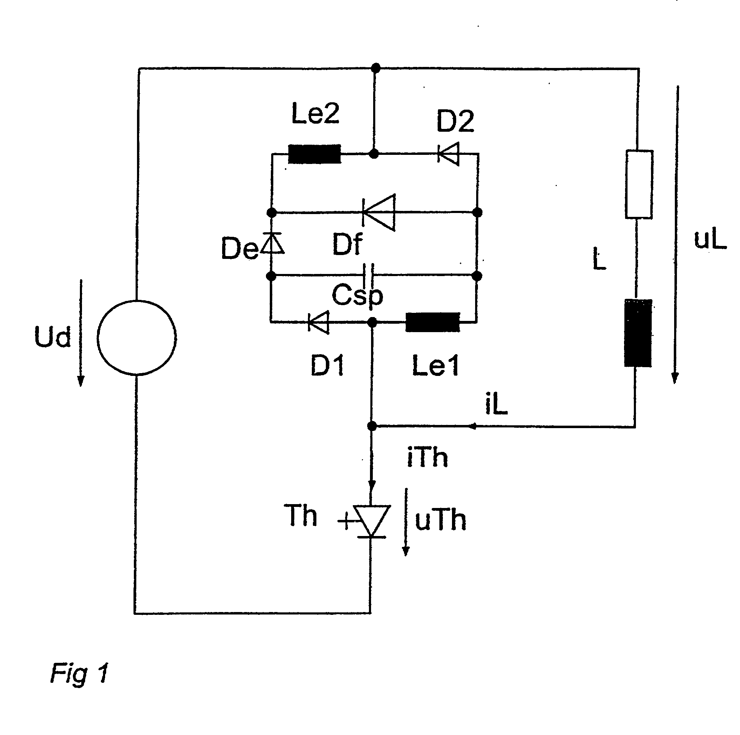

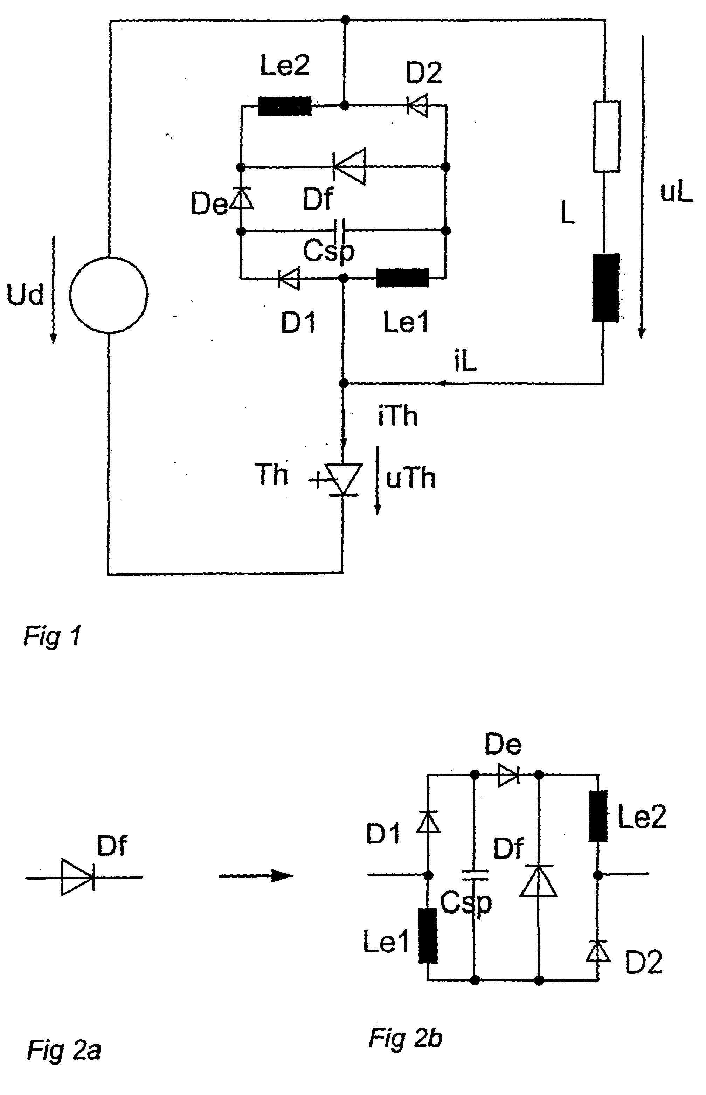

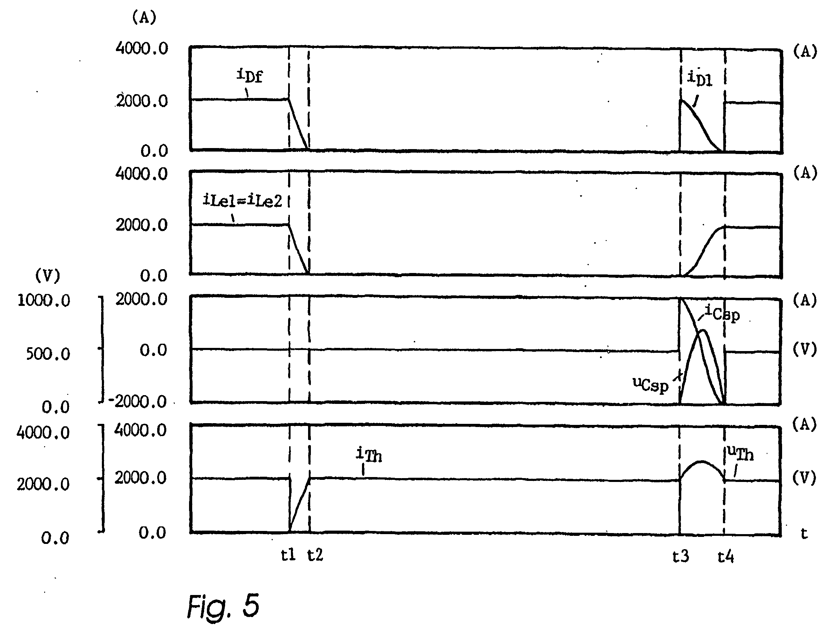

Nachstehend wird die Funktionsweise der Schaltungsanordnung nach Fig. 1 beim Ein- und Abschalten eines Leistungshalbleiterschalters Th anhand der Strom- und Spannungsverläufe nach Fig. 5 näher beschrieben, wobei die unbeschaltete Freilaufdiode Df nach Fig. 2a bereits durch ein Einschaltnetzwerk nach Fig. 2b ersetzt worden ist.

Folgende Verläufe sind nach Fig. 5 über die Zeit t aufgezeigt: Anodenstrom iTh und -spannung uTh des Leistungshalbleiterschalters Th, Strom iCsp und Spannung uCsp eines Speicherkondensators Csp des Einschaltnetzwerks, Ströme iLe1, iLe2 durch die Beschaltungsdrosseln Le1 und Le2 des Einschaltnetzwerkes sowie Ströme iFd durch die Freilaufdiode Df und iD1 durch eine Beschaltungsdiode D1 ebendieses Einschaltnetzwerkes.

Die Beschaltungsdrosseln Le1 und Le2 bewirken die Einschaltentlastung des Leistungshalbleiterschalters Th, indem sie gemeinsam den Stromanstieg di_{Th}/dt im Leistungshalbleiterschalter Th begrenzen.

Der Laststrom iL fließt zunächst in der Freilaufdiode Df in Reihe mit den Beschaltungsdrosseln Le1 und Le2 zur Last L. Beim Einschalten des Leistungshalbleiterschalters Th zum Zeitpunkt t1 steigt der Anodenstrom iTh linear an [di_{Th}/dt = Ud/(Le1 + Le2)], der Strom in der Freilaufdiode iDf nimmt dagegen linear ab bis er zum Zeitpunkt t2 Null wird.

Die Anstiegsgeschwindigkeit des Stromes iTh in dem Leistungshalbleiterschalter Th wird durch die Beschaltungsdrosseln Le1 und Le2 begrenzt. Dadurch wird erreicht, daß die Einschaltverluste des Leistungshalbleiterschalters Th beim Einschalten erheblich reduziert werden.

Beim Abschalten des Leistungshalbleiterschalters Th zum Zeitpunkt t3 kommutiert der Laststrom iL zunächst in den Pfad: Beschaltungsdiode D1 - Speicherkondensator Csp - Beschaltungsdiode D2. Die Kondensatorspannung uCsp steigt an. Da der Speicherkondensator Csp durch die nun stromführenden Beschaltungsdioden D1 und D2 parallel zu den Beschaltungsdrosseln Le1, Le2 geschaltet ist, tritt die Kondensatorspannung uCsp gleichzeitig auf die Beschaltungsdrosseln Le1 und Le2 auf. Dadurch wird der Laststrom während des Zeitabschnitts T4 - t3 von dem Pfad Beschaltungsdiode D1 - Speicherkondensator Csp - Beschaltungsdiode De2 auf den Pfad Beschaltungsdrossel Le1 - Freilaufdiode Df - Beschaltungsdrossel Le2 kommutiert. Der Laststrom iL fließt nun durch die Freilaufdiode Df in Reihe mit den Beschaltungsdrosseln Le1, Le2. Die Energie beider Beschaltungsdrosseln Le1, Le2 wird zunächst im Speicherkondensator Csp zwischengespeichert und dann in die Last L zurückgespeist.

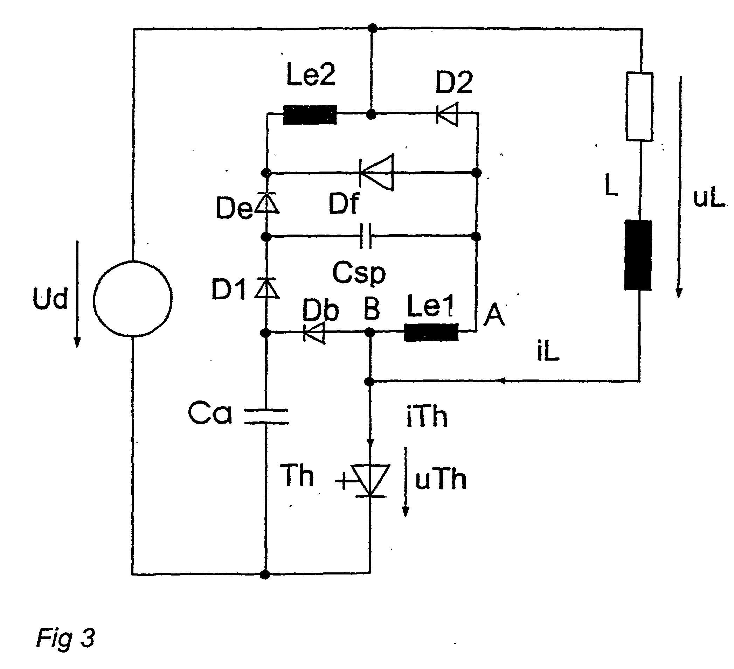

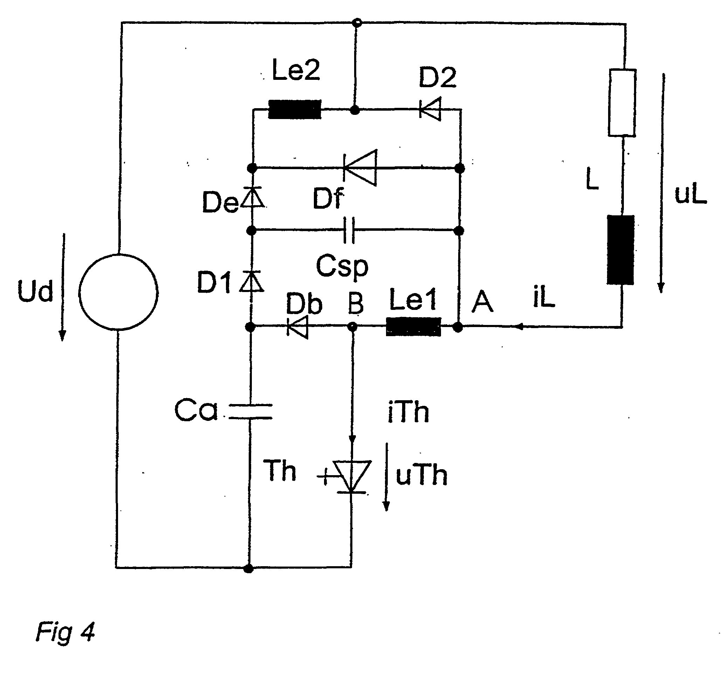

Um den Leistungshalbleiterschalter Th während des Abschaltvorgangs ohne prinzipbedingte Verluste zu entlasten, ist die vorbesprochene Schaltungsanordnung gemäß Fig. 1 um einen Beschaltungskondensator Ca und um eine Beschaltungsdiode Db entsprechend den Fig. 3 und Fig. 4 ergänzt worden. Die Last L kann entweder an Punkt B (Fig. 3) oder Punkt A (Fig. 4) angeschlossen werden.

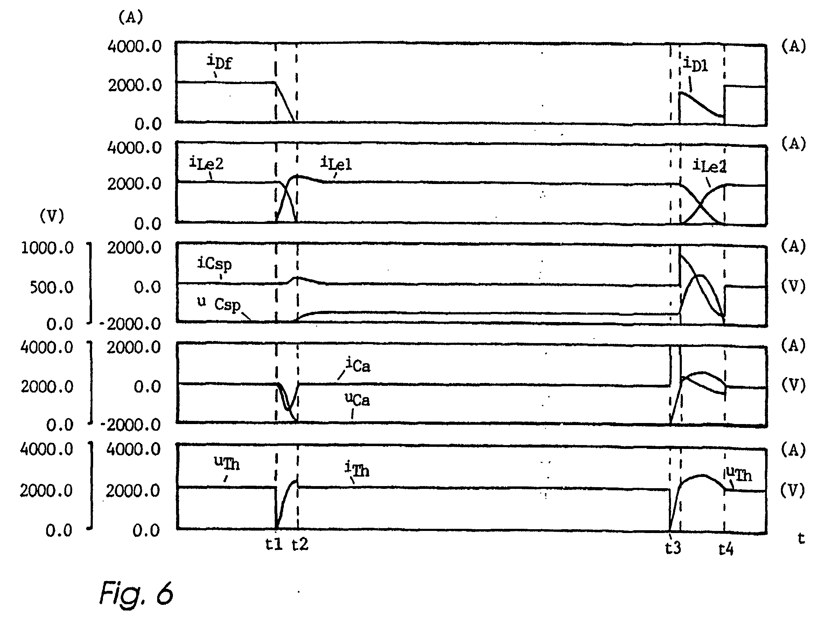

Die Funktionsweise der Schaltungsanordnung nach Fig. 4 beim Ein- und Abschalten des Leistungshalbleiterschalters Th wird anhand der in Fig. 6 gezeigten Strom- und Spannungsveriäufe näher beschrieben.

Folgende Verläufe sind über die Zeit t aufgezeigt: Anodenstrom iTh und -spannung uTh des Leistungshalbleiterschalters Th, Strom iCa und Spannung uCa des Beschaltungskondensators Ca, Strom ICsp und Spannung uCsp des Speicherkondensators Csp, die Ströme iLe1, iLe2 durch die Beschaltungsdrosseln Le1 und Le2 und Ströme iDf durch die Freilaufdiode Df und iD1 durch die Beschaltungsdiode D1.

Der Laststrom iL fließt zunächst in der Freilaufdiode Df in Reihe mit der Beschaltungsdrossel Le2 zur Last L. Beim Einschalten des Leistungshalbleiterschalters Th zum Zeitpunkt t1 steigt der Anodenstrom iTh, begrenzt durch die Beschaltungsdrosseln Le1, Le2, linear an [di_{T1}/dt = Ud/(Lel + Le2)], der Strom in der Freilaufdiode iDf nimmt dagegen linear ab bis er zum Zeitpunkt t2 Null wird. Gleichzeitig wird der Beschaltungskondensator Ca auf Null umgeladen, wobei die ohnehin benötigte Beschaltungsdrossel Le1 als Umschwingdrossel wirkt. Die Energie des Beschaltungskondensators Ca wird in dem Speicherkondensator Csp zwischengespeichert. Da seine Kapazität gegenüber dem Beschaltungskondensator Ca groß bemessen ist, (Csp >= 4Ca), steigt die Spannung uCsp nur geringfügig an.

Beim Abschalten des Leistungshalbleiterschalters Th zum Zeitpunkt t3 kommutiert der Laststrom iL zunächst über die Beschaltungsdiode Db in den Beschaltungskondensator Ca. die Anodenspannung uTh steigt, begrenzt durch den Beschaltungskondensator Ca, linear an [du_{Th}/dt = iL/Ca]. Sobald diese Spannung den Wert der Zwischenkreisspannung Ud erreicht hat, kommutiert der Laststrom iL in den Pfad Beschaltungsdiode D1 - Speicherkondensator Csp - Beschaltungsdiode D2, wodurch der Speicherkondensator Csp parallel zu den Beschaltungsdrosseln Le1, Le2 geschaltet ist. Die nun steigende Kondensatorspannung bewirkt eine Stromkommutierung in den Pfad Freilaufdiode Df - Beschaltungsdrossel Le2. Der Laststrom iL fließt ab dem Zeitpunkt t4 in die Freilaufdiode Df in Reihe mit der Beschaltungsdrossel Le2. Die Energie beider Beschaltungsdrosseln Le1, Le2 wird zunächst im Speicherkondensator Csp zwischengespeichert und dann in die Last L zurückgespeist.

Die angegebenen Beschaltungsanordnungen können nicht nur für Tiefsetzsteller nach Fig. 1 bzw. Fg. 3 oder Fig. 4 angewendet werden, sondern auch ebenso für andere Gleichstromsteller (Hochsetz- und Hoch/Tiefsetzsteller) und ihren Derivaten (Cuk-, SEPIC- und ZETA-Steller). Auch ist das Verfahren für verschiedene steuerbare Leistungshalbleiterschalter (z.B. GTO-Thyristoren, IGBT-Transistoren, BJT-Transistoren, MOSFET-Transistoren u.a.) anwendbar.

### Bezugszeichen

### Fig. 1 bis Fig. 4

- Ca: Beschaltungskondensator
- Csp: Speicherkondensator
- Db, De, D1, D2: Beschaltungsdioden
- Df: Freilaufdiode
- Le1, Le2: Beschaltungsdrosseln
- Th: Leistungshalbleiterschalter
- iL: Laststrom durch die Last L
- Ud: Zwischenkreisgleichspannung
- uL: Spannungsabfall über der Last L

### Fig. 5 und 6

- iDf: Stromverlauf an Df
- iD1: Stromverlauf an D1
- iLe1, iLe2: Stromverläufe an Le1, Le2
- iCa, uCa: Strom- und Spannungsverlauf an Ca
- iCsp, uCsp: Strom- und Spannungsverlauf an Csp
- iTh, uTh: Strom- und Spannungsverlauf an Th

## Patentansprüche

1. Schaltungsanordnung zur Verlustleistungsentlastung eines Leistungshalbleiterschalters, der in Reihe mit einer Last im Zweig einer Gleichspannungsquelle liegt, wobei antiparallel zur Last eine Freilaufdiode angeordnet ist, insbesondere für Gleichstromsteller, **dadurch gekennzeichnet, daß** die Kathode der Freilaufdiode (Df) an die Kathode einer ersten Beschaltungsdiode (De) und an eine erste Beschaltungsdrossel (Le2) angeschlossen ist, daß an die Anode der Freilaufdiode (Df) die Anode einer zweiten Beschaltungsdiode (D2) und eine zweite Beschaltungsdrossel (Le1) angeschlossen ist, wobei die Kathode der zweiten Beschaltungsdiode (D2) mit dem anderen Anschluß der ersten Beschaltungsdrossel (Le2) und zusätzlich mit der Last (L) und der Gleichspannungsquelle (Ud) verbunden ist und die Anode der ersten Beschaltungsdiode (De) mit der Kathode einer dritten Beschaltungsdiode (D1) verbunden ist, deren Anode mit dem zweiten Anschluß der zweiten Beschaltungsdrossel (Le1) und mit der Anode des Leistungshalbleiterschalters (Th) verbunden ist und daß ein Speicherkondensator (Csp) zwischen die Anode der zweiten Beschaltungsdiode (D2) und die Kathode der dritten Beschaltungsdiode (D1) gelegt ist.

2. Schaltungsanordnung zur Verlustleistungsentlastung eines Leistungshalbleiterschalters, der in Reihe mit einer Last im Zweig einer Gleichspannungsquelle liegt, wobei antiparallel zur Last eine zwecks Einschaltentlastung gemäß Anspruch 1 beschaltete Freilaufdiode liegt, **dadurch gekennzeichnet, daß** eine vierte Beschaltungsdiode (Db) anodenseitig zwischen dem Verbindungspunkt der Anode des Leistungshalbleiterschalters (Th) mit der zweiten Beschaltungsdrossel (Le1) und kathodenseitig mit der Anode der dritten Beschaltungsdiode (D1) angeschlossen ist und ein Beschaltungskondensator (Ca) zwischen der Anode der dritten Beschaltungsdiode (D1) und der Kathode des Leistungshalbleiterschalters (Th) angeordnet ist.

3. Schaltungsanordnung nach Anspruch 2, **dadurch gekennzeichnet, daß** die Last (L) an den gemeinsamen Verbindungspunkt von der zweiten Beschaltungsdiode (D2) mit der Freilaufdiode (Df), mit dem Speicherkondensator (Csp) und mit der zweiten Beschaltungsdrossel (Le1) liegt.

4. Schaltungsanordnung nach einem der vorhergehenden Ansprüche, **dadurch gekennzeichnet, daß** der Leistungshalbleiterschalter ein GTO- Thyristor ist.

5. Schaltungsanordnung nach einem der Ansprüche 1 bis 3, **dadurch gekennzeichnet, daß** der Leistungshalbleiterschalter als IGBT-Transitorstrecke ausgebildet ist.

6. Schaltungsanordnung nach einem der Ansprüche 1 bis 3, **dadurch gekennzeichnet, daß** der Leistungshalbleiterschalter ein BJT-Transistor ist.

7. Schaltungsanordnung nach einem der Ansprüche 1 bis 3, **dadurch gekennzeichnet, daß** der Leistungshalbleiterschalter ein MOSFET-Leistungstransistor ist.

8. Schaltungsanordnung nach einem der vorhergehenden Ansprüche, **dadurch gekennzeichnet, daß** der Gleichstromsteller als Tiefsetzsteller und seinen Derivaten ausgeführt ist.

9. Schaltungsanordnung nach einem der vorhergehenden Ansprüche, **dadurch gekennzeichnet, daß** der Gleichstromsteller als Hochsetzsteller und seinen Derivaten ausgeführt ist.

10. Schaltungsanordnung nach einem der vorhergehenden Ansprüche, **gekennzeichnet durch** eine Ausführung als Hoch/Tiefsetzsteller und seiner Derivate.

## Claims

1. A circuit arrangement for reducing the power loss of a power semiconductor switch that lies in series with a load in the branch of a direct voltage source, wherein a free-wheeling diode is arranged anti-parallelly to the load, in particular, for d.c. chopper converters, **characterized in that** the cathode of the free-wheeling diode (Df) is connected to the cathode of a first circuit diode (De) and to a first circuit inductor (Le2), **in that** the anode of a second circuit diode (D2) and a second circuit inductor (Le1) are connected to the anode of the free-wheeling diode (Df), wherein the cathode of the second circuit diode (D2) is connected to the other terminal of the first circuit inductor (Le2), as well as to the load (L) and the direct voltage source (Ud), and wherein the anode of the first circuit diode (De) is connected to the cathode of a third circuit diode (D1), the anode of which is connected to the second terminal of the second circuit inductor (Le1) and to the anode of the power semiconductor switch (Th), and **in that** a storage capacitor (Csp) is arranged between the anode of the second circuit diode (D2) and the cathode of the third circuit diode (D1).

2. The circuit arrangement for reducing the power loss of a power semiconductor switch that lies in series with a load in the branch of a direct voltage source, wherein a free-wheeling diode that is wired in accordance with Claim 1 in order to reduce the turn-on loss lies anti-parallelly to the load, **characterized in that** the anode of a fourth circuit diode (Db) is connected between the connecting point of the anode of the power semiconductor switch (Th) with the second circuit inductor (Le1), and the cathode of this fourth circuit diode is connected to the anode of the third circuit diode (D1), and wherein a circuit capacitor (Ca) is arranged between the anode of the third circuit diode (D1) and the cathode of the power semiconductor switch (Th).

3. The circuit arrangement according to Claim 2, **characterized in that** the load (L) lies at the common connecting point of the second circuit diode (D2) with the free-wheeling diode (Df), with the storage capacitor (Csp) and with the second circuit inductor (Le1).

4. The circuit arrangement according to one of the preceding claims, **characterized in that** the power semiconductor switch is a GTO thyristor.

5. The circuit arrangement according to one of Claims 1 to 3, **characterized in that** the power semiconductor switch is realized in the form of an IGBT transistor section.

6. The circuit arrangement according to one of Claims 1 to 3, **characterized in that** the power semiconductor switch is a BJT transistor.

7. The circuit arrangement according to one of Claims 1 to 3, **characterized in that** the power semiconductor switch is a MOSFET power transistor.

8. The circuit arrangement according to one of the preceding claims, **characterized in that** the d.c. chopper converter is realized in the form of a step-down converter and its derivatives.

9. The circuit arrangement according to one of the preceding claims, **characterized in that** the d.c. chopper converter is realized in the form of a step-up converter and its derivatives.

10. The circuit arrangement according to one of the preceding claims, **characterized in** an embodiment in the form of a step-up/step-down converter and its derivatives.

## Revendications

1. Arrangement de circuit pour la réduction de la puissance perdue d'un interrupteur à semi-conducteurs de puissance qui se trouve en série avec une charge dans la branche d'une source de tension continue, une diode à roue libre étant disposée antiparallèlement à la charge, notamment pour hacheurs de courant, **caractérisé en ce que** la cathode de la diode à roue libre (Df) est raccordée à la cathode d'une première diode de disposition (De) et a une première bobine d'induction de disposition (Le2), **en ce qu'**à l'anode de la diode à roue libre (Df) est raccordée l'anode d'une deuxième diode de disposition (D2) et une deuxième bobine d'induction de disposition (Le1), la cathode de la deuxième diode de disposition (D2) étant reliée à l'autre raccordement de la première bobine de disposition (Le2) et en plus à la charge (L) et à la source de tension continue (Ud) et l'anode de la première diode de disposition (De) à la cathode d'une troisième diode de disposition (D1), dont l'anode est reliée au deuxième raccordement de la deuxième bobine d'induction de disposition (Le1) et à l'anode de l'interrupteur à semi-conducteurs de puissance (Th) et **en ce qu'**un condensateur à accumulateur (Csp) est placé entre l'anode de la deuxième diode de disposition (D2) et la cathode de la troisième diode de disposition (D1).

2. Arrangement de circuit pour la réduction de la puissance perdue d'un interrupteur à semi-conducteurs de puissance qui se trouve en série avec une charge dans la branche d'une source de tension continue, une diode à roue libre étant disposée antiparallèlement à la charge et disposée aux fins d'un délestage au démarrage suivant la revendication 1, **caractérisé en ce qu'**une quatrième diode de disposition (Db) est raccordée du côté anode entre le point de liaison de l'anode de l'interrupteur à semi-conducteurs de puissance (Th) avec la deuxième bobine d'induction de disposition (Le1) et du côté cathode à l'anode de la troisième diode de disposition (D1) et qu'un condensateur de disposition (Ca) est disposé entre l'anode de la troisième diode de disposition (D1) et la cathode de l'interrupteur à semi-conducteurs de puissance (Th).

3. Arrangement de circuit selon la revendication 2, **caractérisé en ce que** la charge (L) se trouve au point de liaison commun de la deuxième diode de disposition (D2) avec la diode à roue libre (Df), avec le condensateur à accumulateur (Csp) et avec la deuxième bobine d'induction de disposition (Le1).

4. Arrangement de circuits selon une des revendications précédentes, **caractérisé en ce que** l'interrupteur à semi-conducteurs de puissance est un thyristor GTO.

5. Arrangement de circuits selon une des revendications 1 à 3, **caractérisé en ce que** l'interrupteur à semi-conducteurs de puissance est conçu comme une section de transistor IGBT.

6. Arrangement de circuits selon une des revendications 1 à 3, **caractérisé en ce que** l'interrupteur à semi-conducteurs de puissance est un transistor BJT.

7. Arrangement de circuits selon une des revendications 1 à 3, **caractérisé en ce que** l'interrupteur à semi-conducteurs de puissance est un transistor de puissance MOSFET.

8. Arrangement de circuits selon une des revendications précédentes, **caractérisé en ce que** le hacheur de courant est réalisé sous forme d'un convertisseur à niveau bas et de son dérivé.

9. Arrangement de circuits selon une des revendications précédentes, **caractérisé en ce que** le hacheur de courant est réalisé sous forme d'un convertisseur à niveau élevé et de son dérivé.

10. Arrangement de circuits selon une des revendications précédentes, **caractérisé par** une réalisation sous forme de convertisseur à niveau élevé/bas et ses dérivés.
